## Europäisches Patentamt
## European Patent Office
## Office européen des brevets

(19)

(11) Veröffentlichungsnummer: **0 116 669**
**B1**

(12) **EUROPÄISCHE PATENTSCHRIFT**

(45) Veröffentlichungstag der Patentschrift:
**10.12.86**

(21) Anmeldenummer: **83103820.3**

(22) Anmeldetag: **20.04.83**

(51) Int. Cl.⁴: **H 03 K 5/135,** H 03 H 11/26,
H 03 L 7/10, G 01 R 29/02

(54) **Integrierte Isolierschicht-Feldeffekttransistor-Verzögerungsschaltung für Digitalsignale.**

(30) Priorität: **17.02.83 DE 8310149 U**

(43) Veröffentlichungstag der Anmeldung:
**29.08.84 Patentblatt 84/35**

(45) Bekanntmachung des Hinweises auf die Patenterteilung:
**10.12.86 Patentblatt 86/50**

(84) Benannte Vertragsstaaten:
**DE FR GB IT NL**

(56) Entgegenhaltungen:
**EP - A - 0 059 802**

(73) Patentinhaber: **Deutsche ITT Industries GmbH,
Hans-Bunte-Strasse 19 Postfach 840, D-7800 Freiburg
(DE)**

(84) Benannte Vertragsstaaten: **DE**

(73) Patentinhaber: **ITT INDUSTRIES INC., 320 Park Avenue,
New York, NY 10022 (US)**

(84) Benannte Vertragsstaaten: **FR GB IT NL**

(72) Erfinder: **Backes, Reiner, Dipl.-Ing., Am Märzengraben 2,
D-7800 Freiburg i. Br. (DE)**
Erfinder: **Langenkamp, Ulrich, Dipl.-Ing.,
Jakobistrasse 15, D-7800 Freiburg i. Br. (DE)**

(74) Vertreter: **Morstadt, Volker, Dipl.-Ing., c/o Deutsche ITT
Industries GmbH Patent/Lizenzabteilung
Postfach 840 Hans-Bunte-Strasse 19,
D-7800 Freiburg/Brsg. (DE)**

ACTORUM AG

## Beschreibung

Die Erfindung betrifft eine integrierte Isolier-schicht-Feldeffekttransistor-Verzögerungsschaltung mit äquidistant in n Schritten stufenweise einstellbarer Verzögerung für Digitalsignale mit 2n signalflussmässig in Serie geschalteten statischen Invertern, die aus einem Schalttransistor und einem Lasttransistor bestehen und von denen jeweils ein ungeradzahliger zusammen mit dem folgenden geradzahligen Inverter eine von mindestens n Stufen mit der Stufenverzögerungszeit t bildet, wobei die Ausgänge der Stufen über einen Eins-aus-n-Auswahlschalter mit dem Verzögerungsausgang gekoppelt sind und eine digitale Messanordnung mit einem Zähler und mit einem dessen Zählerstandausgängen nachgeschalteten Digital-Analog-Wandler die Verzögerung einstellt und regelt, vergleiche den Oberbegriff des Anspruchs 1.

Eine derartige Verzögerungsschaltung ist aus der veröffentlichten Patentanmeldung EP 0 059 802 bekannt. Bei der dort in Fig. 1 gezeigten Anordnung wird die wegen Fertigungsstreuungen an sich schwankende Stufenverzögerungszeit dadurch konstant geregelt, dass während Verzögerungspausen durch Ringschaltung einer ungeraden Anzahl von Invertern eine Schwingung erzeugt wird und aus der gemessenen Frequenz dieser Schwingung ein Regelsignal abgeleitet wird, das über den Digital-Analog-Wandler die Vorspannung der Lasttransistoren steuert, so dass die Stufenverzögerungszeit konstant geregelt wird.

Mit der bekannten Anordnung lassen sich auf Fertigungsstreuungen zurückgehende Schwankungen der Stufenverzögerungszeit nur in beschränktem Umfang ausgleichen, da aufgrund der Beeinflussung der Lasttransistoren der Ziehbereich begrenzt ist. Die Ausgangsspannung des Digital-Analog-Wandlers beeinflusst nämlich über das Gate eines Lasttransistors dessen Widerstand im leitenden Zustand, den sogenannten ON-Widerstand, und dessen Variationsbereich ist für den beabsichtigten Zweck nicht ausreichend.

Der in den Ansprüchen gekennzeichneten Erfindung liegt daher die Aufgabe zugrunde, die bekannte Verzögerungsschaltung so abzuändern und weiterzubilden, dass der Ziehbereich wesentlich vergrössert ist, so dass der obere Wert des Ziehbereichs etwa dem Doppelten des unteren Werts entspricht.

Ein Vorteil der Erfindung ergibt sich unmittelbar aus der Lösung der Aufgabe. Ein weiterer Vorteil besteht darin, dass keine Verzögerungspausen erforderlich sind, während derer eine Messung der tatsächlichen Stufenverzögerungszeit vorgenommen werden muss. Vielmehr erfolgt bei der Erfindung die Regelung auf konstante Stufenverzögerungszeit laufend, wobei die Taktfrequenz als Referenzfrequenz für die Regelung dient.

Als weiterer Vorteil kann angesehen werden, dass mittels der in Anspruch 2 gekennzeichneten Weiterbildung der Erfindung in einfacher Weise nicht nur eine einstellbare Verzögerung eines Digitalsignals erreicht werden kann, sondern dass es auch möglich ist, eine Phasenverschiebung eines Digitalsignals gegenüber der Taktfrequenz zu messen.

Die Erfindung wird nun anhand der Figuren der Zeichnung näher erläutert.

Fig. 1 zeigt in Form eines Blockschaltbilds ein Ausführungsbeispiel der Erfindung,

Fig. 2a und 2b zeigen zwei Möglichkeiten für den in Fig. 1 aus Vereinfachungsgründen nur schematisch angedeuteten Aufbau einer Verzögerungsstufe,

Fig. 3 zeigt zur Verständniserleichterung der Funktion einer Verzögerungsstufe zwei Sätze von entsprechenden Zeitdiagrammen,

Fig. 4 zeigt in Form eines schematischen Schaltbilds ein Ausführungsbeispiel eines bei der Erfindung bevorzugt verwendbaren Digital-Analog-Wandlers, und

Fig. 5 zeigt ebenfalls blockschaltbildmässig ein Ausführungsbeispiel der zur Phasenmessung geeigneten Weiterbildung der Erfindung.

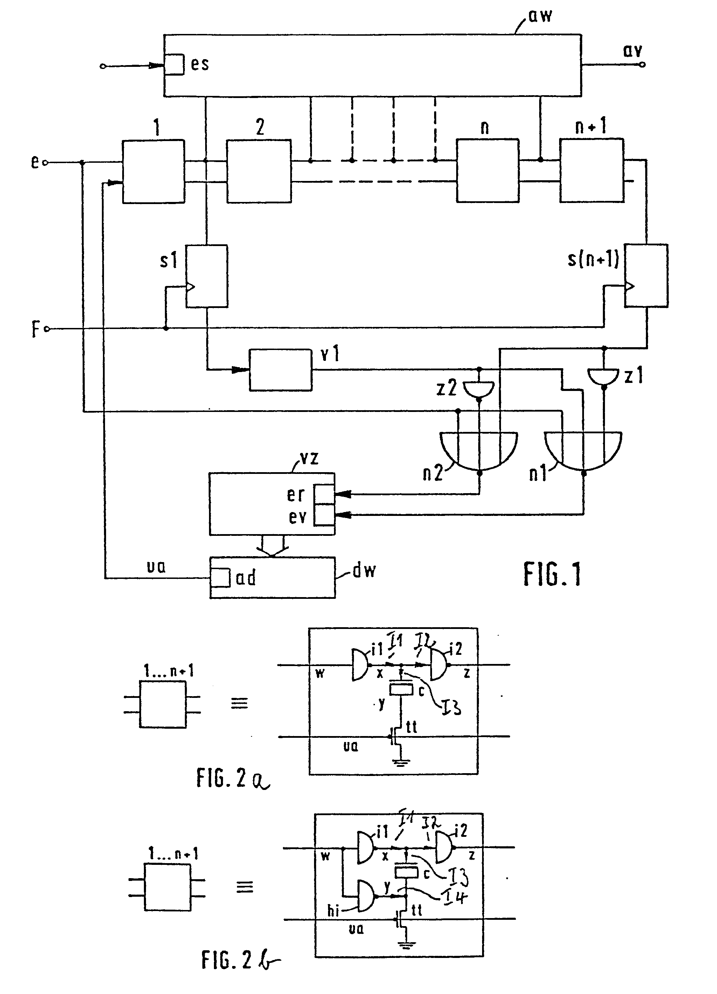

Im schematischen Schaltbild des Ausführungsbeispiels nach Fig. 1 besteht die eigentliche Verzögerungsschaltung aus den Stufen 1, 2 ..., n, wobei der jeweilige Ausgang dieser Stufen mit dem entsprechenden Eingang des Auswahlschalters aw verbunden ist, der über seinen Steuereingang es auf einen der Stufeneingänge eingestellt werden kann. Der angewählte Stufenausgang wird mittels des Auswahlschalters aw auf den Verzögerungsausgang av durchgeschaltet, so dass die entsprechende Anzahl von signalmässig in Serie geschalteten Verzögerungsstufen wirksam sind. Der Signaleingang e liegt dabei am Eingang der ersten Stufe 1.

In Fig. 2a, 2b sind die Innenschaltungen zweier bevorzugter derartiger Stufen gezeigt. Bei Fig. 2a liegt im Signalweg der Stufe der ungeradzahlige Inverter i1, der vom geradzahligen Inverter i2 gefolgt ist. Am Verbindungspunkt des Ausgangs des Inverters i1 mit dem Eingang des Inverters i2 liegt der Pol des Kondensators c, dessen anderer Pol über den gesteuerten Strompfad des Transfertransistors tt mit dem Schaltungsnullpunkt verbunden ist. Am Gate dieses Transfertransistors ist die die Verzögerungszeit t einstellende Spannung ua angelegt. In Fig. 2b ist zusätzlich der Hilfsinverter hi vorgesehen, dessen Eingang am Eingang der Stufe und dessen Ausgang über den Kondensator c am Ausgang des ungeradzahligen Inverters i1 liegt.

Die zwei Inverter i1, i2 (Fig. 2a) bzw. die drei Inverter i1, i2, hi (Fig. 2b) sind statische Inverter, die jeweils aus einem Schalttransistor und einem Lasttransistor bestehen, deren gesteuerte Strompfade in Serie geschaltet sind, wobei der des Schalttransistors am Schaltungsnullpunkt und der des Lasttransistors an einer entsprechenden Betriebsspannung liegt.

Die in Fig. 1 nun zu erläuternden weiteren Schaltungsteile dienen der Regelung auf konstante Verzögerung v. Hierzu liegt der Ausgang der ersten Stufe 1 und der der letzten Stufe n am Eingang der ersten Taktsynchronisierstufe s1, deren Takteingang das Taktsignal F zugeführt ist, für dessen Frequenz fc gilt: fc = 1/nt.

Auf die Stufe n folgt noch die weitere Stufe n + 1, an deren Ausgang der Eingang der letzten Taktsynchronisierstufe s(n + 1) angeschlossen ist, wobei deren Takteingang wiederum das Taktsignal F zugeführt ist.

Als Taktsynchronisierstufen können bekannte derartige Stufen eingesetzt werden, die das jeweilige Eingangssignal mit dem Taktsignal derart synchronisieren, dass das Ausgangssignal nur dann auftritt, wenn das Taktsignal den einen seiner beiden Binärsignalpegel H, L annimmt. Als Beispiel einer derartigen Taktsynchronisierstufe kann die Anordnung nach der Auslegeschrift DE 2 657 281 B2 dienen, wobei das Taktsignal F dann in Form eines üblichen Zwei-Phasen-Taktsignals anzuwenden ist.

Das Ausgangssignal der ersten Taktsynchonisierstufe s1 wird mittels des ersten Verzögerungsglieds v1 um eine Taktperiode des Taktsignals F verzögert. Der Ausgang des ersten Verzögerungsglieds v1 liegt am ersten Eingang des ersten NOR-Gatters n1. Der Ausgang der letzten Taktsynchronisierstufe s(n + 1) liegt über den ersten Zusatzinverter z1 am zweiten Eingang des ersten NOR-Gatters n1, dessen dritter Eingang mit dem Eingang e der Verzögerungsschaltung verbunden ist.

Der Ausgang der letzten Taktsynchronisierstufe s(n + 1) liegt ferner am ersten Eingang des zweiten NOR-Gatters n2. Der Ausgang des ersten Verzögerungsglieds v1 liegt über den zweiten Zusatzinverter z2 am zweiten Eingang des zweiten NOR-Gatters n2, dessen dritter Eingang mit dem Eingang e der Verzögerungsschaltung verbunden ist. Der Ausgang des ersten NOR-Gatters n1 liegt am Vorwärtszähleingang ev des Vorwärts/Rückwärts-Zählers vz, während der Ausgang des zweiten NOR-Gatters n2 an dessen Rückwärtszähleingang er angeschlossen ist.

Schliesslich sind die Zählerstandausgänge des Zählers vz mit dem Paralleleingang des Digital-Analog-Wandlers dw verbunden, dessen Analogausgang ad, der die Spannung ua führt, an den Gates der Transfertransisitoren tt der Stufen 1...n + 1 angeschlossen ist.

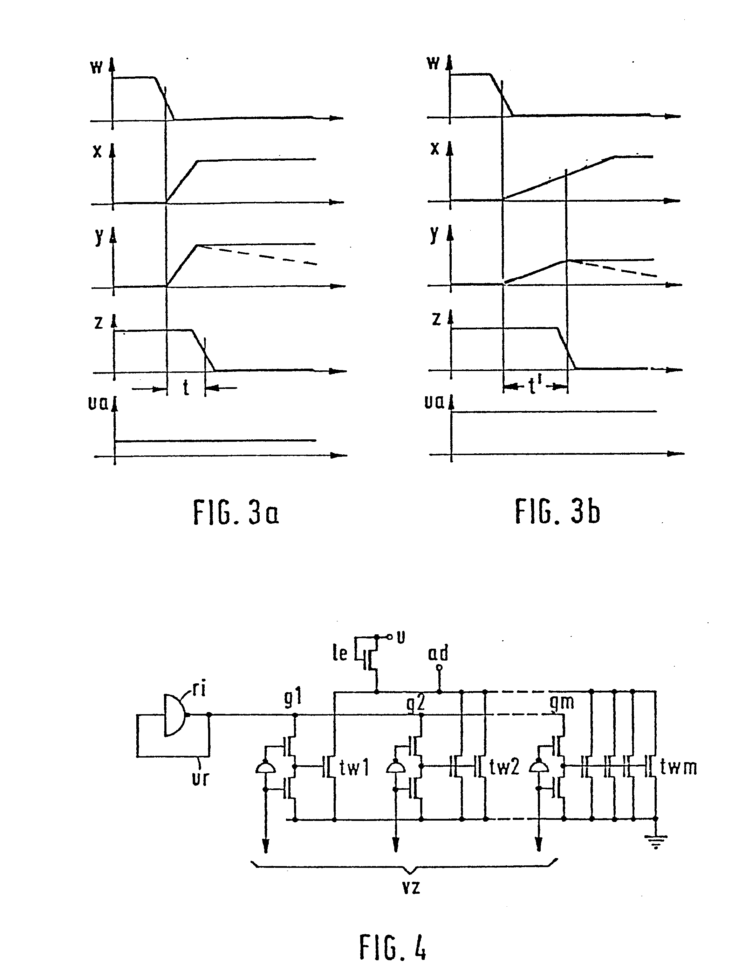

Die steuernde Wirkung der Spannung ua auf die Stufenverzögerungszeit t wird anhand der Fig. 3a, 3b deutlich. In die Fig. 2a, 2b sind Pfeile für (dynamische) Transient-Ströme I1, I2, I3, I4 eingetragen. Je grösser der Strom I2 ist, desto kürzer ist die Verzögerungszeit t der Stufe. Der Strom I1 ist durch die Layout-Dimensionierung des ungeradzahligen Inverters i1 vorgegeben bzw. einstellbar. Da nach der Knotenpunktregel gilt: I2 = I1 - I3, ist die die Verzögerungszeit t bei einmal vorgegebenem Layout bestimmende Grösse der Strom I3. Dieser ist von der Kapazität des Kondensators c und dem Längswiderstand des Transfertransistors tt im leitenden Zustand, dem sogenannten ON-Widerstand, ahängig, wobei gilt, dass je grösser der ON-Widerstand ist, desto kleiner I3 ist. Der ON-Widerstand ist aber von der Steuerspannung ua abhängig. Bei steigender Steuerspannung ua sinkt der ON-Widerstand, wodurch auch I2 kleiner wird und somit die Verzögerungszeit t zunimmt.

In Fig. 3a, 3b haben die Potentiale an den Punkten w, x, y, z den gezeigten Verlauf, wobei für das Potential y die gestrichelte Linie im Falle von Fig. 2b gilt, da sich der Kondensator c langsam entlädt.

Wird nach Fig. 2b der Hilfsinverter hi vorgesehen, so tritt noch der Transientstrom I4 auf, der bei niedriger Steuerspannung ua ( = Transienttransistor tt fast gesperrt) und bei entsprechender Layout-Dimensionierung des Hilfsinverters hi, z.B. I4 ≥ 2I1 bewirkt, dass der Strom I3 das Vorzeichen wechselt und I2 grösser als I1 wird. Damit wird aber das Verzögerungszeit-Minimum kleiner als ohne Hilfsinverter hi, was einen zusätzlichen Vorteil dieser Massnahme darstellt.

In Fig. 3a ist angenommen, dass die Abstimmspannung ua so klein ist, dass die den Transfertransistor tt noch nicht leitend steuert. Dann ist im Fall von Fig. 2a der Zeitverlauf der Ausgangssignale x, y am jeweiligen Ausgang des ungeradzahligen Inverters i1 und des Hilfsinverters hi identisch, und der Kondensator c bleibt wirkungslos. Die Verzögerung ergibt sich dadurch, dass der geradzahlige Inverter i2 erst dann anfängt durchzuschalten, wenn die Ausgangsspannung x des ungeradzahligen Inverters i1 die Schwellspannung des Schalttransistors des geradzahligen Inverters i2 erreicht. Im betrachteten Fall der Fig. 3a liegt somit die kleinste mögliche Stufenverzögerungszeit t vor.

Im Fall der Fig. 3b ist die Ausgangsspannung ua des Digital-Analog-Wandlers dw grösser als die Schwellspannung des Transfertransistors tt, so dass dieser leitet. Der Querstrom des Hilfsinverters hi steht jetzt nur noch teilweise zum Umladen der Knotenkapazität zur Verfügung, da ein Teil durch den Transfertransistor tt fliesst. Ausserdem wird die Ausgangsspannung y des Hilfsinverters hi geklemmt, d.h. sie kann nicht mehr den möglichen Maximalpegel erreichen. Durch diese beiden Effekte entsteht über dem Kondensator c eine Potentialdifferenz, so dass er wirksam ist. Die Ausgangsspannung x des geradzahligen Inverters i1 steigt daher zunächst so lange gleichartig wie die Ausgangsspannung y des Hilfsinverters hi an, bis diese geklemmt wird. Dieser Anstieg ist jedoch flacher als in Fig. 3a. Dann steigt die Ausgangsspannung x aufgrund der Kondensatorwirkung nur noch sehr langsam an, so dass die Trigger-Schwelle des geradzahligen Inverters i2 erst verzögert erreicht wird und dessen Durchschalten auch entsprechend später erfolgt. Daraus ergibt sich die in Fig. 3b eingezeichnete, im Vergleich zum Wert der Fig. 3a grössere Verzögerungszeit t'.

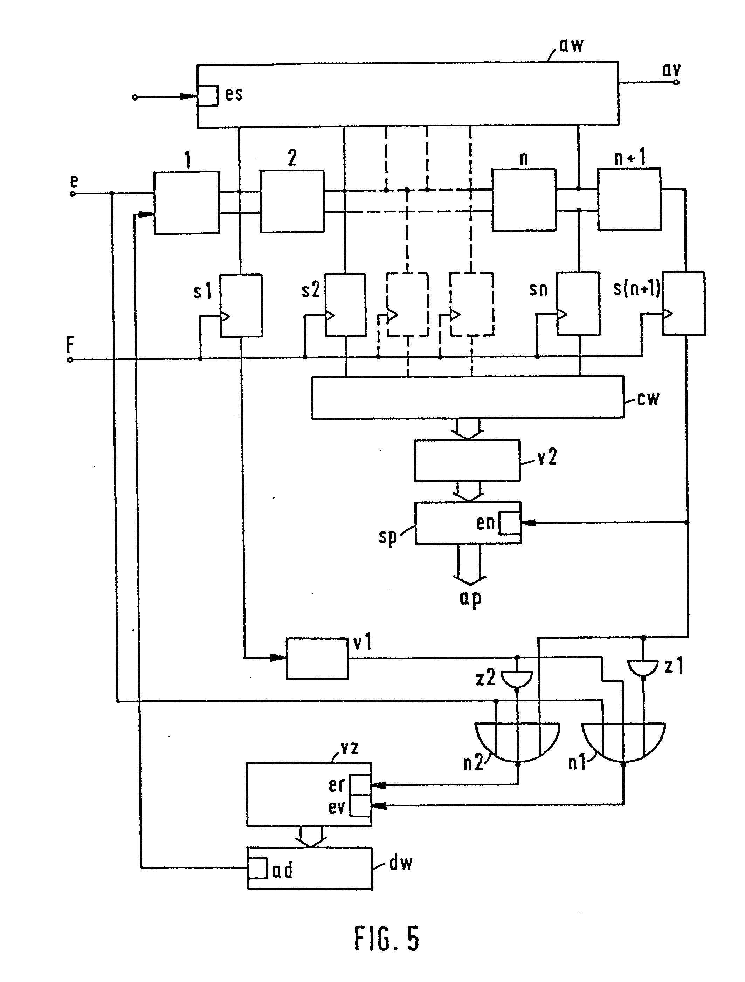

Die Fig. 4 zeigt teilweise schematisch das Schaltbild eines bei der Erfindung bevorzugt verwendbaren Digital-Analog-Wandlers. Er besteht aus einem pro Zählerstandausgang des Vorwärts/Rückwärts-Zählers vz mit seinem gesteuerten Strompfad zwischen dem Schaltungsnullpunkt und dem Wandlerausgang ad liegenden Wandlertransistor tw1, tw2, twm, wobei der Wandlerausgang ad über das Lastelement le, das in Fig. 4 ein Depletion-Transistor ist, an der Betriebsspannung u liegt. Die Wandlertransistoren tw2 bis twm werden aus mehreren parallelgeschalteten Transistoren, die mit dem Wandlertransistor tw1 identisch sind, gebildet. Die Anzahl der parallelgeschalteten Transistoren wird dabei, beginnend mit dem ersten Wandlertransistor tw1, entsprechend einer Zweierpotenzreihe und steigender Wertigkeit der Stellen des Zählerstandes grösser.

Das Gate jedes Wandlertransistors tw1...twm liegt am Ausgang der zugeordneten Gegentaktstufe g1...gm, deren gesteuerter Strompfad zwischen dem Schaltungsnullpunkt und der Referenzspannung ur liegt, die am Ausgang des Referenzinverters ri entsteht, wobei dessen Eingang mit dessen Ausgang verbunden ist. Die geometrischen Abmessungen des Referenzinverters ri, also dessen Layout, sind mit dem des ungeradzahligen Inverters i1 jeder Stufe 1...n + 1 identisch, und sie haben dieselbe Längserstreckung wie diese Stufen. Damit ist gewährleistet, dass allfällige Herstellungstoleranzen sich auf den Referenzinverter ri und die ungeradzahligen Inverter i1 in gleicher Weise auswirken und sich somit kompensieren.

Die jeweils beiden Transistoren der Gegentaktstufen g1...gm sind in üblicher Weise vom entsprechenden Zählerstandausgangs-Signal so angesteuert, dass das Gate des am Schaltungsnullpunkt liegenden Transistors von diesem Signal direkt und das Gate des an der Referenzspannung ur liegenden Transistors über einen entsprechenden Inverter von diesem Signal angesteuert werden.

Obwohl der bevorzugt verwendete Digital-Analog-Wandler nach Fig. 4 sehr einfach aufgebaut ist, bringt seine Anwendung zusammen mit dem Referenzinverter ri als Referenzspannungsquelle den Vorteil, dass der Bereich grösster Linearität des Wandlers unabhängig von Herstellungsstreuungen immer im Bereich der Trigger-Schwelle der ungeradzahligen Inverter i1 liegt. Die an sich vorhandene beträchtliche Nichtlinearität dieses Wandlertyps fällt somit praktisch nicht ins Gewicht. Dieser einfache Wandlertyp ist somit an die Verwendung zusammen mit den Stufen 1...n + 1 angepasst. Die Laufzahl m und somit die Anzahl der einzelnen Wandlertransistoren und -stufen entspricht der Anzahl der Zählerstandausgänge des Vorwärts/Rückwärts-Zählers vz, deren Digitalsignal digital-analog-gewandelt werden sollen. Die Laufzahl m braucht somit nicht identisch mit der Stufenzahl n zu sein.

Die Fig. 5 zeigt ebenfalls teilweise schematisch nach Art eines Blockschaltbilds die bereits eingangs erwähnte Weiterbildung der Erfindung als Phasenmessschaltung zur Bestimmung der Phasenverschiebung zwischen dem Eingangssignal und dem Taktsignal F. Hierzu ist vorgesehen, dass am jeweiligen Ausgang der zweiten bis n-ten Stufe 2...n jeweils eine weitere Taktsynchronisierstufe s2...sn angeschlossen ist, deren Takteingang das Taktsignal F zugeführt ist. Am Ausgang sämtlicher Stufen 1...n + 1 liegt somit eine entsprechende Taktsynchronisierstufe s1...s(n + 1).

An den Ausgängen der zweiten bis n-ten Taktsynchronisierstufe s2...sn liegt der Paralleleingang des Codewandlers cw, der den an den Ausgängen auftretenden Thermometercode in den natürlichen Dualcode umwandelt. Der Thermometercode entspricht dabei der Hälfte des bekannten Johnson-Codes, der bei den sogenannten Johnson-Zählern auftritt, vergleiche z.B. das Buch von D. Becker, H. Mäder «Hochintegrierte MOS-Schaltungen», Stuttgart 1972, Seiten 132 bis 134, insbesondere Tabelle 6.7.

Die Ausgänge des Codewandlers cw liegen über das vom Taktsignal F getaktete zweite Verzögerungsglied v2, dessen Verzögerungszeit gleich der Periodendauer des Taktsignals F ist, am Paralleleingang des Speichers sp, wobei sein Enable-Eingang en mit dem Ausgang der (1 + n)-ten Taktsynchronisierstufe s(n + 1) verbunden ist und dessen Ausgang der Phasenmessausgang ap ist.

Mittels der ersten und der letzten Taktsynchronisierstufe s1, s(n + 1), vergleiche Fig. 1 und 5, wird bei der Erfindung die tatsächliche Verzögerungszeit der der Verzögerung dienenden Stufen 1...n gemessen, wobei in diesem Messkreis wiederum n Stufen liegen, da die erste Taktsynchronisierstufe s1 am Eingang der Stufe 2 liegt. Dies ist zulässig, da sämtliche Stufen untereinander identisch sind. Andererseits wird mittels der Taktsynchronisierstufen s1, s(n + 1) diese Messung auf die Frequenz des Taktsignals F bezogen, so dass die Verknüpfung des Messergebnisses mittels des Vorwärts/Rückwärts-Zählers vz und der erfindungsgemäss beschalteten NOR-Gatter n1, n2 bereits das Regelsignal ergibt.

Mit der Phasenmessschaltung nach Fig. 5 kann die Phase des Eingangssignals in Schritten der Verzögerungszeit t bezüglich des Taktsignals F gemessen werden. Wenn seine Frequenz beispielsweise der vierfachen Referenzträgerfrequenz von Farbfernsehempfängern entspricht und n = — 16 ist, so lässt sich die Phase des Eingangssignals in Schritten von 3,5 ns messen und ebenso dieses Signal mit dieser Schrittweite verzögern. Die eben genannte Anwendung in Farbfernsehempfängern tritt insbesondere bei solchen mit digitaler Signalverarbeitung und -erzeugung, z.B. bei der Horizontalablenkung, auf.

Die Erfindung lässt sich bevorzugt mit Enhancementtransistoren, insbesondere vom n-Kanaltyp, für die Schalttransistoren sämtlicher Inverter und Gatter realisieren, wobei dann bevorzugt Depletiontransistoren als Lastelemente verwendet werden.

Die erfindungsgemässe Anordnung weist bei vergleichbarer Stufenzahl etwa 70% weniger Kristallfläche als die bekannte Anordnung und nur etwa 40% von deren Verlustleistung auf.

**Patentansprüche**

1. Integrierte Isolierschicht-Feldeffekttransistor-Verzögerungsschaltung mit äquidistant in n Schritten stufenweise einstellbarer Verzögerung (v) für Digitalsignale mit 2n signalflussmässig in Serie geschalteten statischen Invertern (i1, i2), die aus einem Schalttransistor und einem Lasttransistor bestehen und von denen jeweils ein ungeradzahliger zusammen mit dem folgenden geradzahligen Inverter eine von mindestens n Stufen 1, 2...n) mit der Stufenverzögerungszeit t bildet, wobei die Ausgänge der Stufen über einen Eins-aus-n-Auswahlschalter (aw) mit dem Verzögerungsausgang (av) gekoppelt sind und eine digitale Messanordnung mit einem Zähler (vz) und mit einem dessen Zählerstandausgängen nachgeschalteten Digital-Analog-Wandler (dw) die Verzögerung (v) einstellt und regelt, gekennzeichnet durch folgende Merkmale:

- die Verzögerungsschaltung hat n + 1 Stufen,
- jede Stufe enthält ferner einen Transfertransistor (tt) und einen integrierten Kondensator (c), dessen einer Pol mit dem Ausgang des ungeradzahligen Inverters (i1) und dessen anderen Pol über den gesteuerten Strompfad des Transfertransistors (tt) mit dem Schaltungsnullpunkt verbunden ist, wobei zur Einstellung der Verzögerung (v) das Gate des Transfertransistors (tt) am Ausgang (ad) des Digital-Analog-Wandlers (dw) liegt,

- der jeweilige Ausgang der ersten bzw. (n + 1)-ten Stufe (1, n + 1) liegt am Eingang einer ersten bzw. letzten Taktsynchronisierstufe (s1, s(n + 1)), deren jeweiligem Takteingang ein Taktsignal (F) zugeführt ist, für dessen Frequenz (fc) gilt: fc = 1/nt,
- der Ausgang der ersten Taktsynchronisierstufe (s1) ist über ein vom Taktsignal (F) getaktetes erstes Verzögerungsglied (v1), dessen Verzögerungszeit gleich der Periodendauer des Taktsignals (F) ist, mit dem ersten Eingang eines ersten NOR-Gatters (n1) verbunden, an dessen zweitem Eingang über einen ersten Zusatzinverter (z1) der Ausgang der letzten Taktsynchronisierstufe (s(n + 1)) und dessen dritter Eingang am Eingang (e) der Verzögerungsschaltung liegt,
- der Ausgang der letzten Taktsynchronisierstufe (s(n + 1)) liegt am ersten Eingang eines zweiten NOR-Gatters (n2), an dessen zweitem Eingang über einen zweiten Zusatzinverter (z2) der Ausgang des ersten Verzögerungsglieds (v1) und dessen dritter Eingang am Eingang (e) der Verzögerungsschaltung liegt, und
- der Ausgang des ersten bzw. des zweiten NOR-Gatters (n1, n2) liegt und am Vorwärts- bzw. Rückwärtszähleingang (ev, er) des als Vorwärts/Rückwärts-Zählers ausgebildeten Zählers (vz).

2. Verzögerungsschaltung nach Anspruch 1, dadurch gekennzeichnet, dass

jede Stufe ferner einen statischen Hilfsinverter (hi) enthält, dessen Eingang am Eingang der Stufe und dessen Ausgang über den Kondensator (c) mit dem Ausgang des ungeradzahligen Inverters (i1) sowie über den gesteuerten Strompfad des Transfertransistors (tt) mit dem Schaltungsnullpunkt verbunden ist.

3. Verzögerungsschaltung nach Anspruch 1 oder 2 als Phasenmessschaltung zur Bestimmung der Phasenverschiebung zwischen dem Eingangssignal und dem Taktsignal (F), gekennzeichnet durch folgende Merkmale:

- am jeweiligen Ausgang der zweiten bis n-ten Stufe (2...n) ist eine zweite bis n-te Taktsynchronisierstufe (s2...sn) angeschlossen, deren Takteingang das Taktsignal (F) zugeführt ist und an deren Ausgängen der Patalleleingang eines Codewandlers (cw) liegt, der den an ihnen auftretenden Thermometercode in den natürlichen Dualcode wandelt, und
- die Ausgänge des Codewandlers (cw) liegen über ein vom Taktsignal (F) getaktetes zweiten Verzögerungsglied (v2), dessen Verzögerungszeit gleich der Periodendauer des Taktsignals (F) ist, am Paralleleingang eines Speichers (sp), dessen Enable-Eingang (en) mit dem Ausgang der (n + 1)-ten Taktsynchronisierstufe (s(n + 1)) verbunden ist und dessen Ausgang der Phasenmessausgang (ap) ist.

4. Verzögerungsschaltung nach einem der Ansprüche 1 bis 3, dadurch gekennzeichnet, dass sämtliche Inverter n-Kanal-Depletion-Load-Inverter sind.

5. Verzögerungsschaltung nach einem der Ansprüche 1 bis 4, gekennzeichnet durch folgende Merkmale:

- der Digital-Analog-Wandler (dw) besteht aus einem pro Zählerstandausgang des Vorwärts/Rückwärts-Zählers (vz) mit seinem gesteuerten Strompfad zwischen dem Schaltungsnullpunkt und dem Wandlerausgang (ad) liegenden Wandlertransistor (tw1...twm), wobei der Wandlerausgang (ad) über ein Lastelement (le) an Betriebsspannung (u) liegt und die Wandlertransistoren (tw2...twm) von mehreren parallelgeschalteten, mit dem ersten Wandlertransistor (tw1) identischen Transistoren gebildet sind, deren Anzahl, beginnend mit dem ersten Wandlertransistor (tw1), einer Zweierpotenzreihe entspricht, und
- das Gate jedes Wandlertransistors (tw1...twm) liegt am Ausgang einer zugeordneten Gegentaktstufe (g1...gm), deren gesteuerter Strompfad zwischen dem Schaltungsnullpunkt und einer Referenzspannung (ur) liegt, die am Ausgang eines Referenzinverters (ri) entsteht, dessen Eingang mit dessen Ausgang verbunden ist und dessen Layout mit dem des ungeradzahligen Inverters (i1) jeder Stufe (1...n + 1) identisch ist sowie dieselbe Längserstreckung wie dieser hat.

## Claims

1. Insulated-Gate field-effect transistor integrated delay circuit for digital signals whereby a delay (v) adjustable in n equidistant steps can be produced using 2n cascaded static inverters (i1, i2) each consisting of a switching transistor and a load transistor, an odd-numbered inverter and a following even-numbered inverter forming one of at least n stages (1, 2...n) giving the delay t and having their outputs coupled to the delay output (av) via a 1-out-of-n selector switch (aw), the delay (v) being adjusted and regulated by a digital measuring arrangement with a counter followed by a digital-to-analog converter (dw), characterized by the following features:

- the delay circuit has n + 1 stages;
- each stage further includes a transfer transistor (tt) and an integrated capacitor (c) one terminal of which is connected to the output of the odd-numbered inverter (i1), and the other terminal of which is grounded through the channel of the transfer transistor (tt), with the gate of the transfer transistor (tt) connected to the output (ad) of the digital-to-analog converter (dw) to permit the delay (v) to be adjusted;
- the outputs of the first stage (1) and the (n + 1)st stage (n + 1) are coupled to the inputs of a first clock-synchronizing stage (s1) and a last clock-synchronizing stage (s(n + 1)), respectively, whose clock inputs are presented with a clock signal (F) of frequency fc = 1/nt;
- the output of the first clock-synchronizing stage (s1) is coupled through a first delay element (v1), which is clocked by the clock signal (F) and gives a delay equal to the period of the clock signal (F), to the first input of a first NOR gate (n1) whose second input is connected to the output of the last clock-synchronizing stage (s(n + 1)) via a first additional inverter (z1), and whose third input is connected to the input (e) of the delay circuit;

- the output of the last clock-synchronizing stage (s(n + 1)) is coupled to the first input of a second NOR gate (n2) whose second input is connected to the output of the first delay element (v1) via a second additional inverter (z2), and whose third input is connected to the input (e) of the delay circuit, and

- the outputs of the first and second NOR gates (n1, n2) are connected, respectivela, to the count up and count down inputs (ev, er) of the counter, which is an up/down counter (vz).

2. A delay circuit as claimed in claim 1, characterized in that

each stage further includes a static auxiliary inverter (hi) whose input is connected to the input of the stage, and whose output is connected to the output of the odd-numbered inverter (i1) through the capacitor (c) and to ground through the channel of the transfer transistor (tt).

3. A delay circuit as claimed in claim 1 or 2, for use as a phase-measuring circuit to measure the difference in phase between the input signal and the clock signal (F), characterized by the following features:

- the outputs of the second to nth stages (2...n) are connected, respectively, to second to nth clock-synchronizing stages (s2...sn) whose clock inputs are fed with the clock signal (F), and whose outputs are coupled to the parallel input of a code converter (cw) which converts the thermometer code provided by the clock-synchronizing stages into the pure phase-2 binary code, and

- the outputs of the code converter (cw) are connected via a second delay element (v2), which is clocked by the clock signal (F) and gives a delay equal to the period of the clock signal (F), to the parallel input of a memory (sp) whose enable input (en) is connected to the output of the (n + 1)st clock-synchronizing stage (s(n + 1)), and whose output is the phase-difference output (ap).

4. A delay circuit as claimed in any one of claims 1 to 3, characterized in that all inverters are n-channel depletion-load inverters.

5. A delay circuit as claimed in any one of claims 1 to 4, characterized by the following features:

- the digital-to-analog converter (dw) consists of one converter transistor (tw1...twm) per output of the up/down counter (vz) which has its channel connected between ground and the converter output (ad), which is connected to the supply voltage (u) via a load device (le), the second to nth converter transistors (tw2...twm) consisting of a plurality of parallel-connected transistors which are identical in design with the first converter transistor (tw1) and whose number, beginning with the first converter transistor (tw1), corresponds to a power-of-two series, and

- the gate of each converter transistor (tw1...twm) is connected to the output of an associated push-pull stage (g1...gm) whose controlled current path is connected between ground and a reference voltage (ur) developed at the output of a reference inverter (ri) whose input is connected to its output, and whose layout is identical to, and has the same longitudinal dimension as, the odd-numbered inverter (i1) of each stage (1...n + 1).

## Revendications

1. Circuit de retard intégré à transistors à effet de champ à grille isolée pour signaux numériques, pouvant produire un retard (v) ajustable en n pas équidistants par l'emploi de 2n inverseurs statiques (i1, i2) en cascade, chacun d'eux consistant en un transistor de commutation et un transistor de charge, un inverseur de rang impair et un inverseur de rang pair le suivant formant l'un de n étages au moins (1, 2...n) fournissant le retard t et ayant leurs sorties couplées à la sortie de retard (av) par l'intermédiaire d'un commutateur de sélection un parmi n (aw), le retard (v) étant ajusté et régulé par un agencement de mesure numérique comprenant un compteur (vz) suivi par un convertisseur analogique-numérique (dw), caractérisé en ce que:

- le circuit de retard comprend n + 1 étages,
- chaque étage comprend en outre un transistor de transfert (tt) et un condensateur intégré (c) dont une borne est connectée à la sortie de l'inverseur impair (i1) et l'autre borne est connectée à la masse par le trajet de courant commandé du transistor de transfert (tt), la grille du transistor de transfert étant connectée à la sortie (ad) du convertisseur numérique-analogique (dw) ce qui permet l'ajustement du retard (v),
- les sorties du premier étage et du (n + 1)ième étage sont respectivement couplées aux entrées d'un premier étage de synchronisation d'horloge (s1) et d'un dernier étage de synchronisation d'horloge (s(n + 1)), dont les entrées d'horloge reçoivent un signal d'horloge (F) de fréquence fc = 1/nt,
- la sortie du premier étage de synchronisation d'horloge (s1) est couplée, à travers un premier élément de retard (v1), qui est déclenché par le signal d'horloge (F) et fournit un retard égal à la période du signal d'horloge (F), à la première entrée d'une première porte NON-ET (n1) dont la deuxième entrée est connectée à la sortie du dernier étage de synchronisation d'horloge (s(n + 1)) via un premier inverseur additionnel (z1), et dont la troisième entrée est connectée à l'entrée (e) du circuit de retard,
- la sortie du dernier étage de synchronisation d'horloge (s(n + 1)) est couplée à la première entrée d'une deuxième porte NON-ET (n2) dont la deuxième entrée est connectée à la sortie du premier élément de retard (v1), via un deuxième inverseur additionnel (z2), et dont la troisième entrée est connectée à l'entrée (e) du circuit de retard, et

- les sorties des première et deuxième portes NON-ET (n1, n2) sont respectivement connectées aux entrées de comptage ascendant et de comptage descendant (ev, er) du compteur, qui est un compteur-décompteur.

2. Circuit de retard selon la revendication 1, caractérisé en ce que chaque étage comprend en outre un inverseur auxiliaire statique (hi) dont l'entrée est connectée à l'entrée de l'étage et dont la sortie est connectée à la sortie de l'inverseur impair

(i1), par l'intermédiaire du condensateur (c) et à la masse par le trajet de courant commandé du transistor de transfert (tt).

3. Circuit de retard selon la revendication 1 ou 2, pour utilisation en circuit de mesure de phase, afin de mesurer la différence de phase entre le signal d'entrée et le signal d'horloge (F), caractérisé en ce que:
- aux sorties des deuxième au nième étages (2...n) sont respectivement connectés des deuxièmes à nième étages de synchronisation d'horloge (s2...sn) dont les entrées d'horloge reçoivent la signal d'horloge (F) et dont les sorties sont couplées à l'entrée parallèle d'un convertisseur de code (cw) qui convertit le code thermométrique fourni par les étages de synchronisation d'horloge en un code binaire pur, et
- les sorties du convertisseur du code (cw) sont connectées, via un deuxième élément de retard (v2), qui est déclenché par le signal d'horloge (F) et fournit un retard égal à la période du signal d'horloge (F), à l'entrée parallèle d'une mémoire (sp) dont l'entrée de validation (en) est connectée à la sortie du nième étage de synchronisation d'horloge (s(n + 1)) et dont la sortie fournit la mesure de la différence de phase (ap).

4. Circuit de retard selon l'une quelconque des revendications 1 à 3, caractérisé en ce que tous les inverseurs sont des inverseurs à charge à appauvrissement à canal N.

5. Circuit de retard selon l'une quelconque des revendications 1 à 4, caractérisé en ce que:
- le convertisseur numérique-analogique (dw) consiste en un transistor de conversion (tw1...twm) par sortie du compteur-décompteur (vz) dont le trajet de courant commandé est connecté entre la masse et la sortie du convertisseur (ad) qui est connectée à la tension d'alimentation (u) par un dispositif de charge (le), les deuxième à nième transistors de conversion (tw2...twm) consistant en plusieurs transistors connectés en parallèle de conception identique à celle du premier transistor de conversion (tw1), leur nombre, à partir du premier transistor de conversion (tw1), suivant une série du puissances de deux, et
— la grille de chaque transistor de conversion (tw1...twm) est connectée à la sortie d'un étage push-pull associé (g1...gm) dont le trajet de courant commandé est connecté entre la masse et un tension de référence (ur) produite à la sortie d'un inverseur de référence (ri) dont l'entrée est connectée à sa sortie, et dont la conception est identique à celle des, et qui possède les même dimensions longitudinales que l'inverseur impair (i1) de chaque étage (1...n + 1).

FIG.1

FIG.2 a

FIG.2 b

FIG. 3a

FIG. 3b

FIG. 4

FIG. 5